# EUROPÄISCHE PATENTSCHRIFT

(11) **EP 1 472 733 B1**
(45) Veröffentlichungstag und Bekanntmachung des Hinweises auf die Patenterteilung: **28.10.2015**
(21) Anmeldenummer: 03734722.6
(22) Anmeldetag: 31.01.2003
(51) Int. Cl.: H01L 25/065, H01L 25/18, H01L 23/00, H01L 23/31, H01L 23/498

(54) **AUFNAHMEVORRICHTUNG FÜR EINE PROGRAMMIERBARE, ELEKTRONISCHE VERARBEITUNGSEINRICHTUNG**
RECEPTACLE FOR A PROGRAMMABLE, ELECTRONIC PROCESSING DEVICE
DISPOSITIF DE LOGEMENT POUR UN DISPOSITIF DE TRAITEMENT ELECTRONIQUE PROGRAMMABLE

(30) Priorität: 31.01.2002 DE 10204071; 20.09.2002 DE 10243684
(43) Veröffentlichungstag der Anmeldung: 03.11.2004
(73) Patentinhaber: Micronas GmbH, 79108 Freiburg i. Br. (DE)
(72) Erfinder: HEBERLE, Klaus, 79276 Reute (DE); SIEBEN, Ulrich, 79279 Vörstetten (DE)
(74) Vertreter: Koch Müller Patentanwaltsgesellschaft mbH
(86) Internationale Anmeldenummer: PCT/EP2003/000987
(87) Internationale Veröffentlichungsnummer: WO 2003/065453

(56) Entgegenhaltungen:
- EP-A2- 1 001 465
- DE-A1- 10 157 457
- US-A- 5 726 500
- US-B1- 6 222 213
- US-B1- 6 337 579
- PATENT ABSTRACTS OF JAPAN vol. 2000, no. 03, 30. März 2000 (2000-03-30) & JP 11 354643 A (MITSUBISHI ELECTRIC CORP), 24. Dezember 1999 (1999-12-24)
- PATENT ABSTRACTS OF JAPAN vol. 1999, no. 09, 30. Juli 1999 (1999-07-30) & JP 11 111913 A (FUJI XEROX CO LTD), 23. April 1999 (1999-04-23)

## Beschreibung

Die Erfindung betrifft eine Aufnahmevorrichtung im Sinne eines Bauelementegehäuses oder einer Umhüllung oder einer Trägereinrichtung für eine programmierbare, elektronische Verarbeitungseinrichtung. Derartige Verarbeitungseinrichtungen bilden in der Regel einen Prozessor, der mindestens eine monolithisch integrierte Schaltung umfaßt. Je nach Anwendungsfall werden sowohl analoge als auch digitale Signale oder Daten verarbeitet. Die relativ kleinen elektronischen Bausteine erlauben es, diese Prozessoren auch noch mit Zusatzschaltungen, wie Speichern usw., in einem relativ kleinen Gehäuse unterzubringen. Man spricht wegen den kleinen Gehäuseabmessungen daher auch von Mikroprozessoren. Wenn mindestens zwei Einzelstrukturen in einer Aufnahmevorrichtung untergebracht sind, bezeichnet man dies zur Unterscheidung der Fälle, bei denen nur eine einzige monolithisch integrierte Schaltung vorliegt, auch als Hybridschaltung.

Die Verwendung von Mikroprozessoren im Bereich der gesamten Technik nimmt ständig zu, da mit ihrer Hilfe Regelungs- und Steuerungsprozesse optimiert werden können. Der zusätzliche Aufwand ist dabei relativ gering und erlaubt dezentrale Lösungen. Ein großes Anwendungsfeld stellt hierbei der Maschinenbau dar, insbesondere der Kraftfahrzeugbereich, der zunehmend auf derartige Mikroprozessoren zurückgreift, um das Fahrzeugverhalten an den verschiedensten Stellen zu optimieren.

In vielen Fällen, bei denen derartige Prozessoren eingesetzt werden können, ergibt sich aber eine grundsätzliche Schwierigkeit dadurch, daß die Zykluszeiten für den Hersteller und den Anwender dieser Prozessoren sehr unterschiedlich sind. Wenn derartige Prozessoren Eingang in ein technisches System finden, dann sollte über die gesamte Entwicklungs-, Planungs-, Fabrikations- und Betriebszeit des zugehörigen Systems ein möglichst gleichbleibendes Produkt für die Fertigung und den Ersatz zur Verfügung stehen.

Bei einer Technologieänderung sind neben den Änderungen der elektrischen Anschlußparameter auch die geänderten Empfindlichkeiten gegenüber Überspannungen, Verpolungen und gegenüber eingestrahlten elektromagnetischen Störungen zu berücksichtigen. Ferner ändert sich auch die Störwirkung gegenüber anderen Schaltungen, beispielsweise durch steilere Takt- und Datenflanken, die über relativ lange Leitungen als elektromagnetische Störsignale wirksam werden.

Die Entwicklung in der Halbleitertechnik eilt in der Regel dem durch den Anwender vorgegebenen Zeitrahmen davon, weil sie aktuellen Technologieveränderungen folgen muß, um immer komplexere Schaltungen realisieren zu können. Überholte Technologien weiter zu verwenden bedeutet parallele Produktionslinien, die in der Regel nicht wirtschaftlich sind, weil die Auslastung nicht gesichert ist.

Es ist daher Aufgabe der im Anspruch 1 gekennzeichneten Erfindung, hier einen geeigneten Lösungsweg anzugeben, der es einerseits dem Halbleiterhersteller ermöglicht, neueste Halbleiterherstellungsverfahren anzuwenden und andererseits auch ermöglicht, dem Anwender eine Garantie für ein langfristig konstantes Produkt anzubieten.

Diese Aufgabe wird durch die im Kennzeichen des Patentanspruchs 1 gegebene Lehre gelöst. Die Aufnahmevorrichtung nach der Erfindung und die Verarbeitungseinrichtung sind dabei nicht als unabhängige Teile anzusehen, sondern der Aufnahmevorrichtung wird eine erste Funktionseinheit der Verarbeitungseinrichtung zugeordnet, die im wesentlichen die elektrischen Außenbedingungen der Verarbeitungseinrichtung definiert. Die eigentliche Verarbeitung findet dabei in einer zweiten Funktionseinheit statt, deren wesentliche Anschlüsse im normalen Betriebsfall von außen nur über die externen Anschlüsse der ersten Funktionseinheit zugänglich sind. Unter wesentlichen Anschlüssen werden hierbei diejenigen Anschlüsse gerechnet, die bezüglich ihrer elektrischen Parameter von außen gesehen kritisch sind, weil ihre Toleranzen eng sind oder weil ihr aktives oder passives Störverhalten zu beachten ist. Unkritische Anschlüsse, beispielsweise Set- oder Reset-Eingänge, können darunter fallen, müssen nicht unbedingt über die erste Funktionseinheit geführt werden, obgleich das langfristig im Hinblick auf die nicht voraussehbare Entwicklung der Technologie sicherer ist. Die Anordnung mit einer ersten und zweiten Funktionseinheit in einer Aufnahmevorrichtung ist ähnlich wie bei einer Hybridschaltung, hat hier jedoch einen ganz anderen Zweck. Die erste Funktionseinheit, die auch aus mehr als einer monolithisch integrierten Schaltung bestehen kann, dient im wesentlichen nur dazu, die Außenbedingungen zu definieren und geeignete Anpaßschaltungen für die zweite Funktionseinheit zur Verfügung zu stellen. Dadurch wird die eigentliche Verarbeitungseinrichtung, die in der zweiten Funktionseinheit enthalten ist und die ebenfalls auch aus mehr als einer monolithisch integrierten Schaltung bestehen kann, gleichsam von außen gesehen maskiert. Neben den reinen Anpaßschaltungen kann die erste Funktionseinheit auch Schaltungsteile von allgemeinerer Funktion enthalten, beispielsweise Oszillatoren, Regelschaltungen für Versorgungsspannungen, Pufferschaltungen, Schutzschaltungen usw. Die Regelschaltungen für Versorgungsspannungen ermöglichen einen autonomen Betrieb des Mikroprozessors in einem Versorgungsnetz mit einer ungeregelten oder einer zu hohen Versorgungsspannung. Dies ist insbesondere für den Betrieb der zweiten Funktionseinheit wichtig, deren Versorgungsspannung gegebenenfalls an die verwendete Technologie angepaßt werden muß, andererseits aber für andere elektronische Schaltungen oder Meßeinrichtungen die ursprüngliche Versorgungsspannung beibehalten werden muß. Da in der Regel in der Verarbeitungseinrichtung auch Speichereinrichtungen vorhanden sind, werden deren Schreib- und Löschspannungen ebenfalls zweckmäßigerweise in der ersten Funktionseinheit erzeugt oder angepaßt.

Die Aufteilung in eine erste und zweite Funktionseinheit erlaubt nun, daß eine technologische Weiterentwicklung der eigentlichen Verarbeitungseinrichtung möglich ist, ohne daß dies von außen berücksichtigt werden muß, sofern bei der ersten Funktionseinheit die Technologie beibehalten wird. Weiterentwicklungen der Technologie sind in der Regel mit höheren Verarbeitungsraten und kleineren Spannungspegeln verknüpft. Die Verarbeitungsraten erhöhen gegebenenfalls über die relativ langen Zuleitungen das zu berücksichtigende Störpotential. Die höheren Verarbeitungsraten lassen wiederum für viele Vorgänge eine sequentielle Datenverarbeitung zu, für die zuvor wegen der geringeren Verarbeitungsgeschwindigkeit eine parallele Verarbeitung erforderlich war. Parallele Verarbeitungen haben aber in der Regel auch parallele Datenein- und -ausgänge zur Folge, wodurch die Anzahl der Anschlußkontakte und damit die erforderliche Kristallfläche erhöht wird. Somit ist es trotz der zunehmenden Funktionalität der Prozessoren erforderlich, die Anzahl der Anschlußkontakte möglichst nicht in gleicher Weise zunehmen zu lassen, sondern zu begrenzen. Eine serielle Ein- und Ausgabe der Daten in der zweiten Funktionseinheit ist somit anzustreben. Dies erfordert aber in der ersten Funktionseinheit entsprechende Umsetzungseinrichtungen.

Dadurch dass die Anpaßschaltungen nicht fest, sondern programmierbar sind, ist die Flexibilität natürlich noch größer, denn dann ist eine Anpassung über das Programm möglich. Ändern sich bei dem Prozessor durch eine neue Technologie beispielsweise die Ein- und Ausgangspegel, dann werden die neuen Spannungspegel der Anpaßschaltungen entsprechend über das Programm angepaßt.

Die Erfindung und vorteilhafte Weiterbildungen werden nun anhand der Figuren der Zeichnung näher beschrieben:
Fig. 1 zeigt schematisch die Aufsicht auf eine typische Aufnahmevorrichtung für eine monolithisch integrierte Schaltung nach dem Stand der Technik,
Fig. 2 zeigt schematisch die Aufsicht auf eine typische Aufnahmevorrichtung für eine Hybridschaltung nach dem Stand der Technik,
Fig. 3 zeigt schematisch die Aufsicht auf eine Aufnahmevorrichtung nach der Erfindung für die Aufnahme einer lateralen Anordnung von einer ersten und zweiten Funktionseinheit,
Fig. 4 zeigt schematisch in Aufsicht eine Aufnahmevorrichtung nach der Erfindung zur Aufnahme einer Stapelanordnung der ersten und zweiten Funktionseinheit,
Fig. 5 zeigt schematisch in Aufsicht eine Aufnahmevorrichtung nach der Erfindung zur Aufnahme einer Kombination aus einer Stapelanordnung und einer lateralen Anordnung,
Fig. 6 zeigt schematisch in Aufsicht eine Aufnahmevorrichtung nach der Erfindung, bei der alle Kontakte der ersten und zweiten Funktionseinheit zunächst auf einen passiven Träger geführt sind,
und
Fig. 7 zeigt schematisch als seitliches Schnittbild eine Aufnahmevorrichtung etwa gemäß Fig. 6, wobei die externen Anschlußkontakte allerdings durch ein Array von Lötpunkten definiert sind.

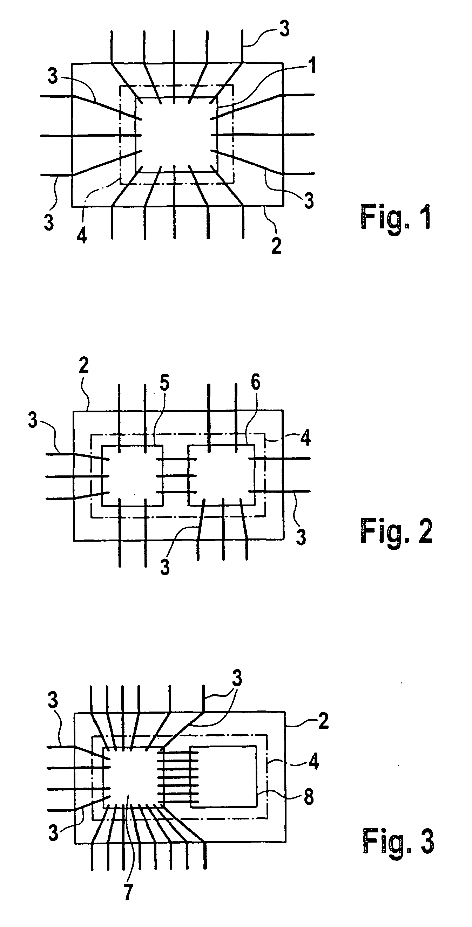

In Fig. 1 ist schematisch in Aufsicht die typische Anordnung einer monolithisch integrierten Schaltung 1 in einer Aufnahmevorrichtung nach dem Stand der Technik dargestellt. Als Aufnahmevorrichtung dient dabei meist ein thermisch verpreßbares Kunststoffgehäuse, dessen äußere Umrandung durch eine Linie 2 wiedergegeben ist. Der Träger der monolithisch integrierten Schaltung 1 ist in der Regel ein flaches Stanzteil 3 aus Metall, der sogenannte "Frame", das einmal die elektrischen Durchführungen für die Anschlußkontakte der monolithisch integrierten Schaltung durch das Kunststoffgehäuse bildet und zum anderen auch eine Plattform 4 zur Aufnahme der monolithisch integrierten Schaltung 1 enthält. In der Regel ist diese Plattform mit einem nach außen führenden Masseanschlußkontakt verbunden. Die Anschlußkontakte der monolithisch integrierten Schaltung 1 sind über Bondverbindungen mit den zugehörigen inneren Anschlüssen des Frames 3 verbunden. Alle externen Zuleitungen zur monolithisch integrierten Schaltung 1 führen über den Frame 3.

Fig. 2 zeigt schematisch die Aufsicht auf eine Hybridschaltung nach dem Stand der Technik. Die Hybridschaltung besteht hierbei aus zwei monolithisch integrierten Schaltungen 5, 6. Wird als Träger wieder ein Frame 3 mit einer Plattform 4 verwendet, dann befinden sich beide monolithisch integrierten Schaltungen nebeneinander auf dieser Plattform. Die Kontaktierungen der monolithisch integrierten Schaltungen 5, 6 erfolgen über Bondverbindungen, die entweder auf die zugehörigen Anschlußbeine des Frames 3 geführt werden oder direkt von Schaltung zu Schaltung. In einigen Fällen verwendet man auch eine Stapelanordnung, bei der die kleinere Schaltung auf die größere aufgeklebt wird. Bei der kleineren Schaltung handelt es sich meist um Speicherschaltungen oder Schaltungen mit speziellen Bauelementen wie Kondensatoren, Spulen, Filtern usw.

Hybridschaltungen werden gerne dort verwendet, wo Schaltungsteile mit unterschiedlichen Grundfunktionen zusammenwirken, beispielsweise eine Analogschaltung und eine Digitalschaltung, eventuell auch noch in Verbindung mit unterschiedlichen Speichertypen. Für jede Schaltung steht damit die optimale Technologie zur Verfugung. Es können auch Produkte unterschiedlicher Hersteller auf diese Weise miteinander kombiniert werden. Als Aufnahmevorrichtungen für Hybridschaltungen finden sich auch ganze Schaltungsplatinen, wobei die Kontaktierung in der Regel ebenfalls über Bondverbindungen erfolgt. Die einzelnen Schaltungen und die Bondverbindungen auf der Platine werden dann durch eine Kunststoffumhüllung geschützt.

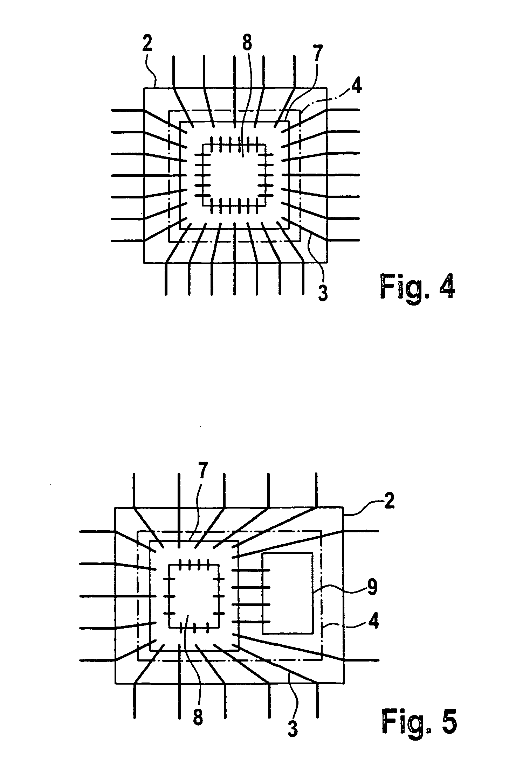

In Fig. 3 ist schematisch die Aufsicht auf eine Aufnahmevorrichtung nach der Erfindung mit einer lateralen Anordnung von einer ersten und zweiten Funktionseinheit 7, 8 dargestellt. Die laterale Anordnung der beiden monolithisch integrierten Funktionseinheiten 7, 8 ist relativ ähnlich zur nebenstehenden Anordnung der beiden monolithisch integrierten Schaltungen 5, 6 von Fig. 2. Der Unterschied besteht allerdings darin, daß in Fig. 3 alle äußeren Kontakte nur mit der ersten Funktionseinheit 7 verbunden sind und die zweite Funktionseinheit 8 nur Verbindungen zur ersten Funktionseinheit 7 aufweist. Der gemeinsame Masseanschluß über die Plattform 4 stellt dabei eine Ausnahme dar. Die Fig. 3 zeigt schon in der schematischen Darstellung, daß bei der Verwendung eines Frames 3 diese Aufnahmevorrichtung auf relativ wenige äußere Anschlußbeine begrenzt ist, weil die Bondverbindungen nur eine begrenzte Geometrie der Kontaktierung zulassen und ein Ausgleich durch die Ausgestaltung der internen Frame-Zuführungen nur teilweise möglich ist. Eine gewisse Abhilfe stellt hier die in Fig. 4 dargestellte Stapelanordnung dar.

Bei der in Fig. 4 dargestellten schematischen Stapelanordnung mit zwei oder mehr Schaltungsteilen auf einer Frame-Plattform 4 bleibt eine zentrale Anordnung wie etwa in Fig. 1 erhalten, so daß alle inneren Frame-Kontakte des Frames 3 vom Rand der ersten Funktionseinheit 7 aus über Bondverbindungen gut erreichbar sind. Durch die Stapelanordnung kommt der ersten Funktionseinheit 7 eine Trägerfunktion für die zweite Funktionseinheit 8 zu. Dies setzt natürlich voraus, daß die Kristallfläche der ersten Funktionseinheit 7 wesentlich größer als die Kristallfläche der zweiten Funktionseinheit 8 ist. Die Gehäuseumrandung bzw. die Grenze der Kunstoffumhüllung wird durch die Linie 2 dargestellt.

Fig. 5 zeigt schematisch als Ausführungsbeispiel eine Kombination aus einer Stapelanordnung und einer lateralen Anordnung auf einer Frame-Plattform 4. Die Stapelanordnung entspricht dabei etwa Fig. 4 und die laterale Anordnung etwa Fig. 3. Die erste Funktionseinheit 7 trägt die zweite Funktionseinheit 8 und ist aber auch noch lateral mit einer weiteren zweiten Funktions- oder Hilfseinheit 9 verbunden, die sich auf der gemeinsamen Frame-Plattform 4 befindet. Alle nach außen weisenden Anschlüsse gehen nur über die ersten Funktionseinheit 7. Bei der Einheit 9 kann es sich beispielsweise um einen Speicherbaustein handeln. Ob dessen Anschlüsse mittelbar über die erste Funktionseinheit 7 oder direkt durch Bondverbindungen auf die zweite Funktionseinheit 8 geführt sind, hängt in erster Linie von den räumlichen Gegebenheiten ab. Die Gehäuseumrandung bzw. die Grenze der Kunstoffumhüllung wird durch die Linie 2 dargestellt.

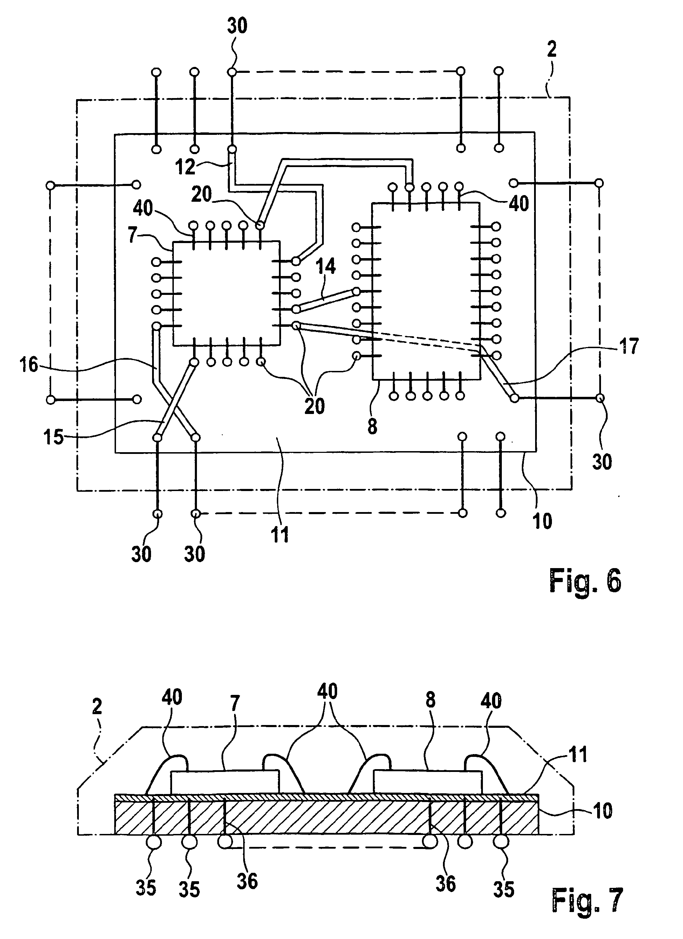

Fig. 6 zeigt schematisch in Aufsicht ein Ausführungsbeispiel für die Aufnahmevorrichtung, bei der das Problem der schlechten Zugänglichkeit der äußeren Anschlüsse 30 von der ersten Funktionseinheit 7 infolge der lateralen Anordnung der ersten und zweiten Funktionseinheit 7, 8 gelöst ist. Ein elektrisch isolierender Träger 10, der beispielsweise aus einer Keramikmasse mit einer oberflächig aufgebrachten Verdrahtungsebene 11 besteht, nimmt an deren Oberfläche die erste und zweite Funktionseinheit 7, 8 auf. Die Verdrahtungsebene 11 kann dabei aus mehreren, voneinander isolierten Verdrahtungsschichten bestehen, um alle Verbindungsleitungen 12, 13, 14, 15, 16 17 und zugehörige Kontaktierungszonen 20 zu bilden. Über Bondverbindungen 40 werden die Zwischenverbindungen von der ersten und zweiten Funktionseinheit 7, 8 zu den Kontaktierungszonen 20 der Verbindungsleitungen hergestellt. Die Verbindungsleitungen sind gegeneinander und gegenüber der Oberfläche isoliert und können sich daher beliebig kreuzen oder unter der ersten oder zweiten Funktionseinheit 7, 8 hindurchgeführt werden, vergleiche beispielsweise die Kreuzung der Leitungen 15, 16 und die Leitung 17, die unterhalb der zweiten Funktionseinheit 8 verläuft. Dadurch sind alle äußeren Anschlüsse 30 der Aufnahmevorrichtung von der ersten Funktionseinheit 7 aus gut erreichbar. Der Träger 10 ist auch mit den äußeren Anschlüssen 30 verbunden oder diese sind in den Träger bei dessen Herstellung schon eingebettet worden. Das Ganze wird von einer Kunststoffumhüllung umschlossen, deren Umrandung durch die strichpunktierte Linie 2 dargestellt ist.

Fig. 7 zeigt schließlich schematisch als seitliches Schnittbild eine weitere Aufnahmevorrichtung mit einem Träger 10 und einer lateralen Anordnung der ersten und zweiten Funktionseinheit 7, 8. Die Anordnung ist dabei etwa ähnlich wie bei Fig. 6. Im Unterschied dazu sind die externen Anschlußkontakte aber durch ein Array von Lötpunkten 35 definiert. Diese Anordnung wird dort verwendet, wo die Anzahl der externen Anschlußkontakte so hoch ist, daß bei einer linearen Anordnung der Anschlußkontakte an den Rändern die gegenseitigen Abstände zu klein werden. Die Lötpunkte 35 sind mit jeweils einer Trägerdurchführung 36 verbunden, der die elektrische Verbindung zur Verdrahtungsebene 11 herstellt. In der Seitenansicht sind auch gut die Bondverbindungen 40 von der ersten und zweiten Funktionseinheit 7, 8 auf die Verdrahtungsebene 11 zu sehen.

Die Erfindung ist selbstverständlich bei der Aufteilung in eine erste und zweite Funktionseinheit nicht auf die Verwendung von monolithisch integrierten Schaltungen beschränkt. Wenn es sich als zweckmäßig erweist, können auch andere Herstellungsverfahren für die einzelnen Schaltungsteile verwendet werden. Wichtig ist allein, daß von außen ein elektrisch konstantes Verhalten der Verarbeitungseinrichtung gewährleistet wird, das durch die Maskierung der eigentlichen Verarbeitungseinrichtung mittels einer ersten Funktionseinheit mit konstanten elektrischen Parametern erreicht wird.

## Patentansprüche

1. Aufnahmevorrichtung mit einer programmierbaren, elektronischen Verarbeitungseinrichtung, die mindestens in eine erste und zweite Funktionseinheit (7, 8) aufgeteilt ist, die separate Bauelemente darstellen,
- die erste Funktionseinheit (7) und die zweite Funktionseinheit (8) als integrierte Funktionseinheiten (7, 8) auf einer gemeinsamen Frame-Plattform angeordnet sind,
- die erste Funktionseinheit (7) alle Ein- und Ausgangsschnittstellen der Verarbeitungseinrichtung bezüglich ihrer elektrischen Eigenschaften definiert,
- Anschlüsse der zweiten Funktionseinheit (8) von außen nur über die erste Funktionseinheit (7) zugänglich sind, und
**dadurch gekennzeichnet, dass**
- die erste Funktionseinheit (7) programmierbare Anpassschaltungen enthält, die über ein Programm die Ein- und Ausgangspegel für die zweite Funktionseinheit (8) anpassen.

2. Aufnahmevorrichtung nach Anspruch 1, bei der die programmierbare, elektronische Verarbeitungseinrichtung ein Mikroprozessor ist.

3. Aufnahmevorrichtung nach Anspruch 1 oder 2, bei der die Verarbeitungseinrichtung mindestens in eine erste und zweite Funktionseinheit (7, 8) aufgeteilt ist, die separate, monolithisch integrierte Bauelemente darstellen.

4. Aufnahmevorrichtung nach einem der vorhergehenden Ansprüche, bei der die Aufnahmevorrichtung zunächst unbestückt ist oder nur einen Teil der programmierbaren elektronischen Verarbeitungseinrichtung enthält, wobei die Aufnahmevorrichtung so ausgebildet ist, daß der fehlende Teil oder die fehlenden Teile der Verarbeitungseinrichtung nachträglich einfügbar sind.

5. Aufnahmevorrichtung nach Anspruch 4, **dadurch gekennzeichnet, daß** der in der Aufnahmevorrichtung enthaltene Teil der ersten Funktionseinheit (7) zuzurechnen ist.

6. Aufnahmevorrichtung nach einem der vorhergehenden Ansprüche, bei der mindestens in einer der Anpaßschaltungen eine Änderung eines Spannungspegels erfolgt.

7. Aufnahmevorrichtung nach Anspruch 6, bei der mindestens ein Versorgungsanschluß der zweiten Funktionseinheit (8) über die erste Funktionseinheit (7) gespeist ist, wobei die Anpaßschaltung einen Spannungsregler enthält.

8. Aufnahmevorrichtung nach einem der Ansprüche 1 bis 5, bei der mindestens in einer der Anpaßschaltungen eine Änderung eines Strompegels erfolgt.

9. Aufnahmevorrichtung nach einem der Ansprüche 1 bis 5, bei der mindestens in einer der Anpaßschaltungen eine Umsetzung von einem seriellen Datenstrom in einen parallelen Datenstrom oder von einem parallelen Datenstrom in einen seriellen Datenstrom erfolgt.

10. Aufnahmevorrichtung nach einem der Ansprüche 1 bis 5, **dadurch gekennzeichnet, daß** mindestens in einer der Anpaßschaltungen eine Zwischenspeicherung von ein- oder ausgehenden Daten erfolgt.

11. Aufnahmevorrichtung nach einem der Ansprüche 1 bis 5, bei der für mindestens eine der Anpaßschaltungen ein Meßmodus programmierbar ist.

12. Aufnahmevorrichtung nach Anspruch 11, bei der im Meßmodus mindestens für eine der Anpaßschaltungen ein direkter Signalpfad von einem nach außen führenden Anschluß der Aufnahmevorrichtung zu einem Anschluß der zweiten Funktionseinheit (8) mittels des Programms durchschaltbar ist, wobei der über die Anpaßschaltung führende mittelbare Signalpfad abgeschaltet ist.

## Claims

1. Mounting device with programmable electronic processing equipment divided at least into a first and a second functional unit (7, 8), which functional units represent separate components,
- the first functional unit (7) and the second functional unit (8) are arranged as integrated functional units (7, 8) on a common frame platform,
- the first functional unit (7) defines all input and output interfaces of the processing unit with respect to the electrical characteristics thereof and
- terminals of the second functional unit (8) are externally accessible only by way of the first functional unit (7),
**characterised in that**
- the first functional unit (7) includes programmable adaptation circuits which by way of a program adapt the input and output level for the second functional unit (8).

2. Mounting device according to claim 1, in which the programmable electronic processing equipment is a microprocessor.

3. Mounting device according to claim 1 or 2, in which the processing equipment is divided at least into a first and second functional unit (7, 8), which functional units represent separate, monolithically integrated components.

4. Mounting device according to any one of the preceding claims, in which the mounting device is initially unequipped or includes only a part of the programmable electronic processing equipment, wherein the mounting device is constructed so that the missing part or missing parts of the processing equipment are introducible subsequently.

5. Mounting device according to claim 4, **characterised in that** the part included in the mounting device is to be attributed to the first functional unit (7).

6. Mounting device according to any one of the preceding claims, in which a change in a voltage level takes place at least in one of the adaptation circuits.

7. Mounting device according to claim 6, in which at least one power supply terminal of the second functional unit (8) is supplied with power by way of the first function unit (7), wherein the adaptation circuit includes a voltage regulator.

8. Mounting device according to any one of claims 1 to 5, in which a change in a voltage level takes place at least in one of the adaptation circuits.

9. Mounting device according to any one of claims 1 to 5, in which conversion from a serial data flow to a parallel data flow or from a parallel data flow to a serial data flow takes place at least in one of the adaptation circuits.

10. Mounting device according to any one of claims 1 to 5, **characterised in that** an intermediate storage of entering and exiting data is carried out at least in one of the adaptation circuits.

11. Mounting device according to any one of claims 1 to 5, in which a measuring mode is programmable for at least one of the adaptation circuits.

12. Mounting device according to claim 11, in which in the measuring mode a direct signal path from an outwardly leading terminal of the mounting device to a terminal of the second functional unit (8) can be switched through by means of the program at least for one of the adaptation circuits, wherein the signal path leading indirectly by way of the adaptation circuit is switched off.

## Revendications

1. Dispositif de logement avec un dispositif de traitement électronique programmable, qui est divisé au moins en une première et une deuxième unités fonctionnelles (7, 8), qui représentent des composants séparés,
- la première unité fonctionnelle (7) et la deuxième unité fonctionnelle (8) sont disposées en tant qu'unités fonctionnelles intégrées (7, 8) sur une plate-forme de châssis commune,
- la première unité fonctionnelle (7) définit toutes les interfaces d'entrée et de sortie du dispositif de traitement en ce qui concerne leurs propriétés électriques,
- les bornes de la deuxième unité fonctionnelle (8) ne sont accessibles de l'extérieur que par la première unité fonctionnelle (7) et
**caractérisé en ce que**
- la première unité fonctionnelle (7) contient des circuits d'adaptation programmables qui adaptent au moyen d'un programme les niveaux d'entrée et de sortie pour la deuxième unité fonctionnelle (8).

2. Dispositif de logement selon la revendication 1, dans lequel le dispositif de traitement électronique programmable est un microprocesseur.

3. Dispositif de logement selon la revendication 1 ou 2, dans lequel le dispositif de traitement est divisé au moins en une première et une deuxième unités fonctionnelles (7, 8), qui représentent des composants séparés intégrés de façon monolithique.

4. Dispositif de logement selon l'une quelconque des revendications précédentes, dans lequel le dispositif de logement est d'abord non équipé ou ne comporte qu'une partie du dispositif de traitement électronique programmable, dans lequel le dispositif de logement est configuré de telle manière que la partie manquante ou les parties manquantes du dispositif de traitement puisse(nt) être ajoutée(s) ultérieurement.

5. Dispositif de logement selon la revendication 4, **caractérisé en ce que** la partie contenue dans le dispositif de logement doit être attribuée à la première unité fonctionnelle (7).

6. Dispositif de logement selon l'une quelconque des revendications précédentes, dans lequel un changement d'un niveau de tension est effectué au moins dans l'un des circuits d'adaptation.

7. Dispositif de logement selon la revendication 6, dans lequel au moins une borne d'alimentation de la deuxième unité fonctionnelle (8) est alimentée via la première unité fonctionnelle (7), dans lequel le circuit d'adaptation contient un régulateur de tension.

8. Dispositif de logement selon l'une quelconque des revendications 1 à 5, dans lequel un changement d'un niveau de courant est effectué au moins dans l'un des circuits d'adaptation.

9. Dispositif de logement selon l'une quelconque des revendications 1 à 5, dans lequel une conversion d'un flux de données série à un flux de données parallèle ou d'un flux de données parallèle à un flux de données série est effectuée au moins dans l'un des circuits d'adaptation.

10. Dispositif de logement selon l'une quelconque des revendications 1 à 5, **caractérisé en ce qu'**une mémorisation intermédiaire de données entrantes ou sortantes est effectuée au moins dans l'un des circuits d'adaptation.

11. Dispositif de logement selon l'une quelconque des revendications 1 à 5, dans lequel un mode de mesure est programmable pour au moins l'un des circuits d'adaptation.

12. Dispositif de logement selon la revendication 11, dans lequel, dans le mode de mesure, un chemin de signal direct d'une borne du dispositif de logement menant vers l'extérieur à une borne de la deuxième unité fonctionnelle (8) peut être interconnecté au moyen du programme au moins pour l'un des circuits d'adaptation, le chemin de signal indirect conduisant via le circuit d'adaptation étant déconnecté.
